(19) **Europäisches Patentamt / European Patent Office / Office européen des brevets**

(11) **EP 4 195 091 A1**

(12) # EUROPEAN PATENT APPLICATION
published in accordance with Art. 153(4) EPC

(43) Date of publication:
**14.06.2023 Bulletin 2023/24**

(21) Application number: **20952856.1**

(22) Date of filing: **11.09.2020**

(51) International Patent Classification (IPC):
**G06F 30/28** (2020.01)     **G06Q 10/04** (2023.01)

(52) Cooperative Patent Classification (CPC):
**G06F 30/28; G06Q 10/04**

(86) International application number:
**PCT/CN2020/114896**

(87) International publication number:
**WO 2022/052068 (17.03.2022 Gazette 2022/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Ltd. China
Beijing 100102 (CN)**

(72) Inventors:
• **ZHOU, Xiaozhou
Beijing 100102 (CN)**

• **SUN, Tianrui
Beijing 100191 (CN)**
• **LIANG, Xiao
Beijing 100082 (CN)**
• **SCHNEEGASS, Daniel
80637 München (DE)**

(74) Representative: **Isarpatent
Patent- und Rechtsanwälte Barth
Charles Hassa Peckmann & Partner mbB
Friedrichstrasse 31
80801 München (DE)**

(54) **TARGET AVAILABLE MODEL-BASED ENVIRONMENT PREDICTION METHOD AND APPARATUS, PROGRAM, AND ELECTRONIC DEVICE**

(57)    A target available model-based environment prediction method and apparatus, a program, and an electronic device. A training sample is generated on the basis of predetermined environmental data, and on the basis of a fluid mechanics model and a Gaussian simulation model, training is performed by using the training sample so as to obtain a target available model (S101). When pollution diffusion occurs, only the current actual environmental data needs to be input into the target available model, such that an actual predicted value of a time-dependent pollution concentration sequence at a calibration position (B1-B4, S1-S5) can be determined (S102), thereby implementing quick and accurate pollution diffusion prediction.

Fig. 1a

Processed by Luminess, 75001 PARIS (FR)

EP 4 195 091 A1

**Description**

**Technical field**

The embodiments of the present invention relate to the field of computers, in particular to a method and apparatus for training a pollution diffusion model, a program, and an electronic device thereof.

**Background art**

A leakage of pollutants (e.g. industrial toxic gases) is a serious accident, which could cause serious human casualties. If a leak occurs, it is necessary to immediately find out how the pollutants are spreading, and determine a danger zone, in order to carry out an appropriate evacuation. If pollution occurs in an open place free of obstacles, it is generally sufficient to use a Gaussian simulation model.

However, in the real world, pollution often occurs in areas of complex terrain containing surface buildings and walkways, such as industrial parks. In such a scenario, if a Gaussian diffusion model is used, obstacles and buildings are often ignored, so the diffusion result obtained is not precise enough; if computational fluid dynamics (CFD) simulation is carried out, the speed is often very slow, so it is not possible to make a prediction in a timely manner within a short time.

On this basis, there is a need for a faster and more accurate solution for environment prediction.

**Summary of the invention**

To solve the above problems, the embodiments of the present invention provide an environment prediction method and apparatus based on a target available model, a program, and an electronic device thereof, to at least partly solve the above problems.

According to a first aspect of the embodiments of the present invention, an environment prediction method based on a target available model is provided, the method comprising the following steps:

generating a training sample based on predetermined environment data, and using the training sample to perform training based on a fluid dynamics model and a Gaussian simulation model, to obtain a target available model;
based on real environment data, using the target available model to determine a real environment prediction value of a time-related pollution concentration sequence for a calibration position.

Optionally, in one embodiment, environment data used for training is determined, the environment data comprising a pollution source position and a pollution source leakage strength of a pollution diffusion region as well as meteorological data of the pollution diffusion region; a time-related pollution concentration sequence of a calibration position is determined based on the environment data used for training; a training sample is generated, having the calibration position and the environment data used for training as features and the time-related pollution concentration sequence of the calibration position as a label. In this way, a sufficient number of training samples can be acquired by simulation, so as to cover a variety of possible real leakage scenarios, thus increasing the adaptability of the target available model.

Optionally, in one embodiment, a sensor position is determined; a computational fluid dynamics algorithm and/or a Gaussian simulation algorithm is/are used to determine pollution concentration data of the sensor position based on the pollution source data and meteorological data; the pollution concentration data of the sensor position is determined to be environment data used for training. In this way, the prediction accuracy of the target available model is increased by means of sensor data.

Optionally, in one embodiment, the training sample is used to perform data fusion based on the fluid dynamics model and the Gaussian simulation model according to the environment data used for training, to obtain the time-related pollution concentration sequence of the calibration position. In this way, a more accurate training sample can be obtained.

Optionally, in one embodiment, the features and label of the training sample are used to subject the initial model to model training, and when a training prediction value of the initial model for the label of the training sample meets a preset condition, the initial model at this time is determined to be the target available model, wherein the preset condition comprises the difference between a real value and the training prediction value of the label not exceeding a threshold. In this way, the prediction accuracy of the target available model is increased.

Optionally, in one embodiment, an evacuation speed is determined; an evacuation route is determined from real prediction values of time-related pollution concentration sequences of multiple calibration positions according to the evacuation speed, wherein the evacuation route is a time ordered array containing multiple elements, the elements belonging to the time-related pollution concentration sequences of the multiple calibration positions, a time difference between two adjacent elements in the array not exceeding the ratio of a distance between the two adjacent elements

to the evacuation speed, and a pollution concentration of the elements in the array not exceeding a preset pollution threshold. In this way, an evacuation route adapted to evacuation speed can be determined according to a prediction result for diffusion, to guide groups of people to evacuate safely and quickly.

According to a second aspect of the embodiments of the present invention, an environment prediction apparatus based on a target available model is further provided, the apparatus comprising:

a training module, for generating a training sample based on predetermined environment data, and using the training sample to perform training based on a fluid dynamics model and a Gaussian simulation model, to obtain a target available model;

a prediction module, for using the target available model, based on real environment data, to determine a real environment prediction value of a time-related pollution concentration sequence for a calibration position.

According to a third aspect of the embodiments of the present invention, a computer program is provided, comprising computer-executable instructions which, when executed, cause at least one processor to perform the method as described in any of the above embodiments.

According to a fourth aspect of the embodiments of the present invention, an electronic device is provided, comprising a memory, a processor, and a computer program stored on the memory and capable of being run on the processor, wherein the processor, upon executing the program, performs the method as described in any of the above embodiments of the present invention.

According to a fifth aspect of the embodiments of the present invention, a storage medium is provided, the storage medium comprising a stored program, wherein, when the program is run, a device comprising the storage medium is controlled to perform the method as described in any of the embodiments of the present invention.

In the embodiments of the present invention, a training sample is generated based on predetermined environment data, and the training sample is used to perform training based on a fluid dynamics model and a Gaussian simulation model, to obtain a target available model by training. When a spread of pollution occurs, real prediction values of a time-related pollution concentration sequence at a calibration position can be determined simply by inputting current real environment data directly into the target available model, thereby achieving fast and accurate prediction of the spread of pollution.

## Brief description of the drawings

The following drawings are merely intended to describe and explain the present invention schematically, without limiting the scope thereof. In the drawings,

Fig. 1a is a schematic flow chart of a method for training a pollution diffusion model as provided in an embodiment of the present invention.
Fig. 1b is a schematic diagram of calibration positions as provided in an embodiment of the present invention.
Fig. 2 is a structural schematic diagram of an environment prediction apparatus based on a target available model as provided in an embodiment of the present invention.
Fig. 3 is a structural schematic diagram of an electronic device provided in an embodiment of the present invention.

Key to the drawings:

S101: generating a training sample based on predetermined environment data, and using the training sample to perform training based on a fluid dynamics model and a Gaussian simulation model, to obtain a target available model;
S102: based on real environment data, using the target available model to determine a real environment prediction value of a time-related pollution concentration sequence for a calibration position;
B1, B2, B3, B4, S1, S2, S3, S4 and S5: calibration positions;
201: training module;
202: prediction module;
203: evacuation route determining module;
1001: processor;
1002: memory; and
1003: display unit.

## Detailed description of the invention

To enable clearer understanding of the technical features, objectives and effects of embodiments of the present invention, particular modes of implementation of embodiments of the present invention are now explained with reference to the drawings.

When pollutants spread in an industrial park, the accuracy of the prediction result of a Gaussian simulation model is too low due to the presence of large numbers of buildings and walkways on the surface; if a computational fluid dynamics (CFD) model is used for prediction, the efficiency is too low. On this basis, the embodiments of the present invention provide a fast and accurate solution for predicting the spread of pollution. Specifically, two aspects are included, the first aspect being the training of a target available model, and the second aspect being prediction based on the target available model.

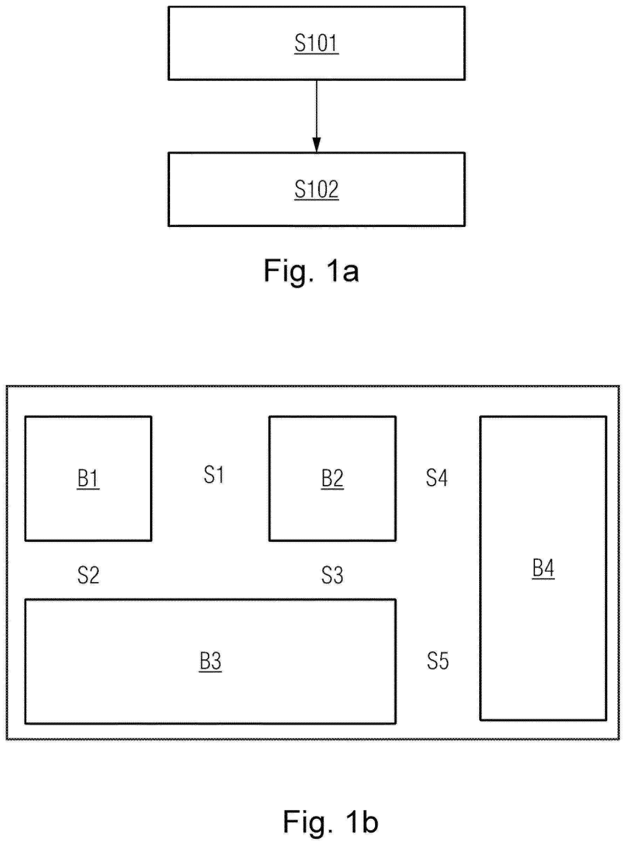

For the first aspect of the embodiments of the present invention, as shown in Fig. 1a, Fig. 1a is a schematic flow chart of a method for training a pollution diffusion model as provided in an embodiment of the present invention, for use in a pollution diffusion scenario containing surface buildings and walkways, the method comprising:

S101, generating a training sample based on predetermined environment data, and using the training sample to perform training based on a fluid dynamics model and a Gaussian simulation model, to obtain a target available model.

The training sample may be obtained from a real case of pollution. However, there is actually not much data of this type.

Thus, simulation may also generally be used to obtain the training sample. In this case, the environment data used for training is not real environment data; it may be simulated and set using a computer according to actual needs, and the training sample obtained is no longer data obtained in a real case of pollution, but simulated data. As modern meteorology is quite mature, simulated data of this type is quite realistic, and so can be used as the training sample.

The basic method of obtaining the training sample by simulation is to determine environment data (including the position and strength of the pollution source, and meteorological data, etc.) in advance, i.e. the training sample may be obtained using equations for atmospheric motion.

In real applications, the position of the pollution source and the strength of the pollution may be set within a region grid that has already been divided up in advance. In general, within an industrial park which has already been determined, a number of pollution source positions and pollution strengths may be set according to potential pollution source positions and possible pollution strengths.

The meteorological data should include wind direction and wind speed. For certain specific types of pollution sources, the meteorological data may also include other meteorological data, including for example atmospheric temperature, atmospheric humidity, etc. For example, if a potential pollution source might produce pollutants in the form of suspended particles, then atmospheric humidity may be added as one type of environment data to the environment data for this pollution source which is used for training. Thus, pollutant data may also include the pollutant type, in which case the meteorological data may also include meteorological parameters capable of influencing the polluting spread of this pollutant type.

In real applications, the pollutant type may be for example a toxic gas or aerosol, etc. produced by a chemical leak, or may be soot, various gases or fog, etc. produced by a fire.

Thus, it is only necessary to give a calibration position, and it will then be possible to determine a time-related pollution concentration sequence of the calibration position based on the environment data used for training, and thereby generate a training sample having the calibration position and the environment data used for training as training features and the time-related pollution concentration sequence as a label.

Regarding Gaussian simulation models, a Gaussian diffusion model is suitable for uniform atmospheric conditions, and areas of open, flat ground; a pollution diffusion model for a high-altitude point source may perform simulation in the following way:

$$C(x, y, z, H) = \frac{q}{2\pi u \sigma_y \sigma_z} \exp\left(\frac{-y^2}{2\sigma_y^2}\right) \left\{ \exp\left[\frac{-(z-H)^2}{2\sigma_z^2}\right] + \exp\left[\frac{-(z+H)^2}{2\sigma_z^2}\right] \right\}.$$

Here, C is the pollution concentration at any point in space, q is the pollution source leak strength, x, y and z are the distances from the point to the origin of the coordinate system in the three directions in the coordinate system respectively, H is the height of the pollution source, u is the wind speed, $\sigma_y$ is a diffusion coefficient in the y direction and $\sigma_z$ is a diffusion coefficient in the z direction.

Thus, it is only necessary to have determined q, u and H, while $\sigma_y$ and $\sigma_z$ are regular coefficients which have already been determined, and it is then possible to obtain the pollution concentration at any point C(x, y, z) based on the Gaussian simulation model.

In the case of complex terrain, a Gaussian simulation model is not very accurate; having determined environment data, a fluid dynamics model such as a finite difference method, finite volume method or lattice Boltzmann method (LBM), etc. may be used to obtain the pollution concentration at any point in space.

For example, when using a finite difference method, space may be divided up into multiple grids, with the already-determined pollution source data serving as initial conditions at a particular point in the grids, and meteorological data serving as constraint conditions; a differential form of a predetermined atmospheric motion equation is used to compute the pollution concentrations at other grid points one by one, thereby obtaining the pollution concentration at any point in space. Thus, the training sample may be obtained based on the pollution concentration at each point in space obtained by simulation.

Obviously, for the same environment data used for training, the pollution concentration sequence will be different at different calibration positions. The pollution concentration sequence may be in the form of an ordered array; for example, for the ith calibration position, the pollution concentration sequence thereof $P_i = (P_{t1}, P_{t2}, ..., P_{tn})$. The time sequence t1 to tn may have a fixed time interval.

Specifically, because data obtained by CFD simulation is more precise but takes longer to obtain than a Gaussian model, data obtained by CFD simulation may be called high-precision data, and data obtained by a Gaussian model may be called low-precision data. Thus, based on actual needs, it is possible to use for example a data fusion method such as a multiple-precision method, or a regression method such as a neural network and response surface method, etc. to obtain a training sample based on high-precision data and low-precision data.

The specific fusion method may be as follows: a designated region is divided up into multiple parts in advance, for example including a complex terrain part and a simple terrain part; a CFD model is used for the complex terrain part to obtain a training sample, and a Gaussian simulation model may be used for the simple terrain part to obtain a training sample. The data fusion method allows both the precision and computing efficiency of the obtained training sample to be taken into account.

Training samples for different environments can be obtained based on simulation after combining pollution source data and meteorological data. A sufficient number of training samples can be obtained through a sufficient number of simulations. In model training, ample training samples can cover a variety of possible real leakage scenarios, avoiding the phenomenon of underfitting or overfitting which might arise in model training, and increasing the adaptability of the target available model.

In addition, the numbers of training samples for different conditions may be adjusted based on actual needs. For example, if easterly winds are predominant at the location of a real park, then a greater amount of easterly wind data can be set in the meteorological data, so as to generate a greater number of training samples corresponding to easterly wind conditions.

The statement that a correspondence exists between the environment data used for training and the training samples means that a training sample obtained for one type of environment data is not suitable for other environment data. For example, supposing that environment parameters are (pollution source 1, strength 1, easterly wind, wind speed 1 m/s), a training sample obtained under these conditions is obviously not suitable for conditions with environment parameters (pollution source 2, strength 1, southerly wind, wind speed 2 m/s).

The training sample obtained may be a training sample having the calibration position and the environment data used for training as features and the time-related pollution concentration sequence of the calibration position as a label.

The calibration position may be preset according to actual needs. For example, calibration positions may include surface buildings and walkways. There may be multiple calibration positions; one calibration position may be in one-to-one correspondence with one surface building or walkway. As shown in Fig. 1b, Fig. 1b is a schematic diagram of calibration positions as provided in an embodiment of the present invention. In this schematic diagram, the calibration positions B1, B2, B3 and B4 respectively represent 4 surface buildings, and the calibration positions S1 to S5 respectively represent five streets.

Using the features of the training sample (i.e. the calibration position and the environment data used for training) as inputs of an initial model, it is possible to obtain a training prediction value of the initial model for the label of the training sample. It is thereby possible to adjust the model according to the training prediction value of the label and a real value of the label; for example, based on a preset loss function, methods such as forward propagation and directional propagation are used to adjust parameters in the initial model, and after multiple iterations for the initial model, an initial model whose training prediction value for the label meets a preset condition is finally obtained, at which time the initial model is the target available model.

The preset condition may for example be that the accuracy of the training prediction value of the label relative to the real value meets a certain condition, etc. In one embodiment, the preset condition may be that for any training sample, any element in the difference between the training prediction value of the initial model for the label of the training sample and the real value of the label does not exceed a preset threshold. As stated above, the label of the training sample is a sequence containing multiple elements, and the difference between the training prediction value and the real value thereof is also a sequence. If no element in the difference exceeds the preset difference, this indicates that the target available model obtained at this time is already accurate enough; in this way, the prediction accuracy of the target available model for real leaks can be increased.

In real applications, a given park may also have sensors placed therein in advance. In this case, the sensor positions can be determined in advance; when this method is used, the abovementioned simulation method can still be used to obtain pollution concentration data for the sensor positions based on the pollution source data and meteorological data. The pollution concentration data for the sensor positions may also be a time-related sequence.

When prediction is actually being performed, the pollution concentration data for the sensor positions can be obtained directly and serve as known parameters. Thus, in a training sample, the pollution concentration data for the sensor positions can also serve as environment data used for training, i.e. the features of the training sample may also include the pollution concentration data for the sensor positions. When this method is used, the pollution concentration data for the sensor positions takes part in model prediction as independent variables, i.e. the pollution concentration data at the sensor positions is independent input parameters of the model, because the data actually measured by the sensors can be regarded as a more reliable data source than simulation data, thus increasing the accuracy of the target available model.

S102, based on real environment data, using the target available model to determine a real environment prediction value of a time-related pollution concentration sequence for a calibration position.

When the target available model F has been determined, once the variables have been specified (i.e. determined by means of real environment data), the average concentration $C(Si)$ on the street at each calibration position (including) can be predicted very quickly as a function $C(Si) = F(t, q, v, \theta)$ of time $t$, leakage strength $q$ and meteorological data (including wind speed $v$ and wind direction $\theta$).

The real environment data may be acquired through various channels; for example, pollution source data may be obtained directly by means of a sensor close to a pollution source, or obtained by conjecture based on pollution-related phenomena, or obtained by pre-judgement of a potential pollution source; meteorological data may be obtained by observation, or acquired from a meteorological department, and so on. The present solution does not impose specific limitations in this respect.

Real environment prediction values of the time-related pollution concentration sequence at various positions can be obtained by simply inputting real environment data into the target available model that has already been trained, wherein the various positions obviously also include the calibration position.

In the embodiments of the present invention, a training sample is generated based on predetermined environment data, and the training sample is used for training based on a fluid dynamics model and a Gaussian simulation model, to obtain a target available model by training. When a spread of pollution occurs, real prediction values of a time-related pollution concentration sequence at a calibration position can be determined simply by inputting current real environment data directly into the target available model, thereby achieving fast and accurate prediction of the spread of pollution.

In one embodiment, if related data of a sensor is added in the process of model training, then when actual prediction is performed, it is also possible to acquire pollution concentration data for the sensor position directly by means of the sensor, and then determine the pollution source data, meteorological data and pollution concentration data for the sensor position to be real environment data as inputs, to obtain real prediction values of the pollution concentration sequence at the calibration position.

Because sensor factors have been taken into account during model training, the pollution concentration at each calibration position at this time is in fact a function of time, pollution source data, meteorological data and real-time data from the sensor. With a sensor provided in advance, real pollution data can be collected when a spread of pollution occurs, and can increase the accuracy of the model's prediction result for each location when inputted as environment data (because firstly prediction data at the sensor position must tally with pollution concentration data obtained by the sensor).

In one embodiment, when there are multiple calibration positions, an evacuation route may also be determined according to the calibration positions. Specifically, an evacuation speed (for example, approximately equal to a person's walking speed of 1 m/s) may first be determined, and it is thereby possible to obtain a time ordered array containing multiple elements when a starting point and ending point have already been determined.

The elements in this ordered array are arranged in chronological order, each element coming from the pollution concentration sequences of the multiple calibration positions. Furthermore, since the calibration positions may be real walkways, it is possible to limit the time difference between two adjacent elements in the array to no more than the ratio of the distance between the two adjacent elements (i.e. the real distance between the two calibration positions corresponding to the two adjacent elements) to the evacuation speed (thereby ensuring that evacuated staff are able to walk from one calibration position to another, adjacent calibration position, as long as they move at the evacuation speed), with the pollution concentrations of elements in the array not exceeding a preset pollution threshold (thus ensuring that the pollution concentration at any point on the evacuation route will not exceed regulations). In this way, when a pollution accident occurs, an evacuation route can be estimated accurately and quickly, to achieve the safe evacuation of groups of people.

A target model in the present application may also be applied in scenarios of safe evacuation of indoor storeys. In such a scenario, because the accuracy of the Gaussian model will be subject to a considerable tendency, the use of the Gaussian simulation model can be reduced in advance when training the target model, and the CFD model can be used to a greater extent, to increase the accuracy of the target model.

After obtaining the target model by training, when a fire occurs indoors in a tall building, the pollution source strength q and pollution source position resulting from the outbreak of fire can first be determined, then the abovementioned target model already obtained by training can be used to predict an indoor pollution concentration sequence. In this case, because the fire has occurred indoors, it can be concluded that the wind speed $v = 0$ and the wind direction $\theta = 0$, and it is thus possible to compute the pollution concentration sequence $C(Si) = F(t, q, 0, 0)$ at a calibration position at any time t. The pollutants in this case may include water vapour, carbon monoxide, carbon dioxide, etc. produced during the fire.

Furthermore, the number of storeys is directly related to storey height, so by determining the actual heights of calibration positions, it is possible to respectively obtain the pollution concentration sequence of each calibration position in the same storey (at the same height), and obtain pollution concentration sequences in different storeys (i.e. at different heights). Then, based on the obtained pollution concentration sequences of the calibration positions on each storey, a safe evacuation route can be obtained, to facilitate the evacuation of groups of people. The safe evacuation route obtained in this way likewise contains a time ordered array; see the above explanation for details regarding the limitations imposed on the elements in the array. In addition, within this array, it is also a requirement that the height difference between the calibration positions corresponding to each pair of adjacent elements must not exceed a preset value, or the number of storeys corresponding to the calibration positions not exceed 1, to avoid continuity of the safe evacuation route across storeys.

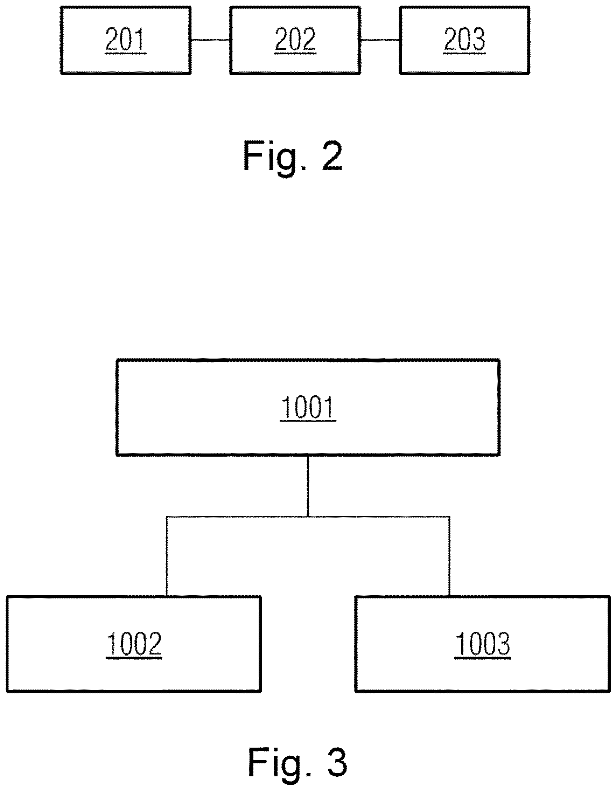

Corresponding to the first aspect, the embodiments of the present invention further provide an environment prediction apparatus based on a target available model, as shown in Fig. 2; Fig. 2 is a structural schematic diagram of an environment prediction apparatus based on a target available model as provided in an embodiment of the present invention, the apparatus comprising:

a training module 201, for generating a training sample based on predetermined environment data, and using the training sample to perform training based on a fluid dynamics model and a Gaussian simulation model, to obtain a target available model;

a prediction module 202, for using the target available model, based on real environment data, to determine a real environment prediction value of a time-related pollution concentration sequence for a calibration position.

Optionally, the training module 201 determines environment data used for training, the environment data comprising a pollution source position and a pollution source leakage strength of a pollution diffusion region as well as meteorological data of the pollution diffusion region; determines a time-related pollution concentration sequence of a calibration position based on the environment data used for training; and generates a training sample having the calibration position and the environment data used for training as features and the time-related pollution concentration sequence of the calibration position as a label.

Optionally, the training module 201 determines a sensor position; uses a computational fluid dynamics algorithm and/or a Gaussian simulation algorithm to determine pollution concentration data of the sensor position based on the pollution source data and meteorological data; and determines the pollution concentration data of the sensor position to be environment data used for training.

Optionally, the training module 201 uses the training sample to perform data fusion based on the fluid dynamics model and the Gaussian simulation model according to the environment data used for training, to obtain the time-related pollution concentration sequence of the calibration position.

Optionally, the training module 201 uses the features and label of the training sample to subject the initial model to model training, and when a training prediction value of the initial model for the label of the training sample meets a preset condition, determines the initial model at this time to be the target available model, wherein the preset condition comprises the difference between a real value and the training prediction value of the label not exceeding a threshold.

Optionally, the apparatus further comprises an evacuation route determining module 203, for determining an evacuation speed; determining an evacuation route from real prediction values of time-related pollution concentration sequences of multiple calibration positions according to the evacuation speed, wherein the evacuation route is a time ordered array containing multiple elements, the elements belonging to the time-related pollution concentration sequences of the multiple calibration positions, a time difference between two adjacent elements in the array not exceeding the ratio of a distance between the two adjacent elements to the evacuation speed, and a pollution concentration of an element in the array not exceeding a preset pollution threshold.

In a third aspect of the embodiments of the present invention, a computer program is further provided, comprising computer-executable instructions which, when executed, cause at least one processor to execute the prediction method as described in any one of the embodiments of the present invention.

In a fourth aspect of the embodiments of the present invention, an electronic device is further provided, comprising a memory, a processor, and a computer program stored on the memory and capable of being run on the processor, wherein the processor, upon executing the program, performs the prediction method as described in any one of the embodiments of the present invention.

Fig. 3 shows a structural schematic diagram of an electronic device provided in an embodiment of the present invention. As shown in Fig. 3, the electronic device comprises: one or more processors 1001, a memory 1002, a display unit 1003, and one or more programs, wherein the one or more programs are stored in the memory and configured to be executed by the one or more processors, and the one or more programs comprise for performing the method as described in any embodiment of the present invention.

In a fifth embodiment of the embodiments of the present invention, a storage medium comprising a stored program is further provided, wherein, when the program is run, a device comprising the storage medium is controlled to perform the prediction method as described in any one of the embodiments of the present invention.

It must be explained that a computer storage medium of the present invention may be a computer-readable signal medium or a computer-readable storage medium, or any combination of these two types of medium. The computer-readable medium may for example be, but is not limited to being, an electrical, magnetic, optical, electromagnetic, infrared or semiconductor system, apparatus or device, or any combination of these. More specific examples of computer-readable storage media may include but are not limited to: electrically connected, portable computer magnetic disks with one or more leads, hard disks, random access storage media (RAM), read-only storage media (ROM), erasable programmable read-only storage media (EPROM or flash memory), optical fibers, portable compact magnetic disk read-only storage media (CD-ROM), optical storage media, magnetic storage media , or any suitable combination of these. In the present invention, the computer-readable storage medium may be any tangible medium containing or storing a program, which program can be used by an instruction execution system, apparatus or device or used in combination therewith. In the present invention, the computer-readable signal medium may comprise a data signal propagated in a baseband or as part of a carrier wave, with computer-readable program code carried therein. Such a propagated data signal may take various forms, including but not limited to an electromagnetic signal, an optical signal, or any suitable combination of these. The computer-readable signal medium may also be any computer-readable medium other than a computer-readable storage medium, which computer-readable medium can send, propagate or transmit a program configured to be used by an instruction execution system, apparatus or device or used in combination therewith. The program code included on the computer-readable medium may be transmitted using any suitable medium, including but not limited to: wirelessly, electric wires, optical cables, RF, etc., or any suitable combination of these.

It should be understood that although the present invention is described with reference to various embodiments, it is by no means the case that each embodiment contains only one independent technical solution; this manner of presentation is adopted herein purely for clarity. Those skilled in the art should consider this specification in its entirety; the technical solutions in the embodiments may also be suitably combined to form other embodiments understandable to those skilled in the art.

The above are merely particular schematic modes of implementation of the embodiments of the present invention, and are not intended to limit the scope of the embodiments of the present invention. All equivalent changes, amendments and combinations made by any person skilled in the art without departing from the concept and principles of the embodiments of the present invention should be included in the scope of protection of the embodiments of the present invention.

## Claims

1. An environment prediction method based on a target available model, the method comprising the following steps:

generating a training sample based on predetermined environment data, and using the training sample to perform training based on a fluid dynamics model and a Gaussian simulation model, to obtain a target available model (S101);
based on real environment data, using the target available model to determine a real environment prediction value of a time-related pollution concentration sequence for a calibration position (S102).

2. The method as claimed in claim 1, wherein the step of generating a training sample based on predetermined environment data comprises:

determining environment data used for training, the environment data comprising a pollution source position and a pollution source leakage strength of a pollution diffusion region as well as meteorological data of the pollution diffusion region;

determining a time-related pollution concentration sequence of a calibration position based on the environment data used for training;

generating a training sample having the calibration position and the environment data used for training as features and the time-related pollution concentration sequence of the calibration position as a label.

3. The method as claimed in claim 2, wherein the step of determining environment data used for training further comprises:

determining a sensor position;

using a computational fluid dynamics algorithm and/or a Gaussian simulation algorithm to determine pollution concentration data of the sensor position based on the pollution source data and meteorological data;

determining the pollution concentration data of the sensor position to be environment data used for training.

4. The method as claimed in claim 2, wherein the step of determining a time-related pollution concentration sequence of a calibration position based on the environment data used for training comprises:
using the training sample to perform data fusion based on the fluid dynamics model and the Gaussian simulation model according to the environment data used for training, to obtain the time-related pollution concentration sequence of the calibration position.

5. The method as claimed in claim 2, wherein the step of using the training sample to perform training based on a fluid dynamics model and a Gaussian simulation model, to obtain a target available model, comprises:
using the features and label of the training sample to subject the initial model to model training, and when a training prediction value of the initial model for the label of the training sample meets a preset condition, determining the initial model at this time to be the target available model, wherein the preset condition comprises the difference between a real value and the training prediction value of the label not exceeding a threshold.

6. The method as claimed in claim 2, the method further comprising:

determining an evacuation speed;

determining an evacuation route from real environment prediction values of time-related pollution concentration sequences of multiple calibration positions according to the evacuation speed, wherein the evacuation route is a time ordered array containing multiple elements, the elements belonging to the time-related pollution concentration sequences of the multiple calibration positions, a time difference between two adjacent elements in the array not exceeding the ratio of a distance between the two adjacent elements to the evacuation speed, and a pollution concentration of the elements in the array not exceeding a preset pollution threshold.

7. An environment prediction apparatus based on a target available model, the apparatus comprises:

a training module (301), for generating a training sample based on predetermined environment data, and using the training sample to perform training based on a fluid dynamics model and a Gaussian simulation model, to obtain a target available model;

a prediction module (303), for using the target available model, based on real environment data, to determine a real environment prediction value of a time-related pollution concentration sequence for a calibration position.

8. A computer program, comprising computer-executable instructions which, when executed, cause at least one processor to perform the method as claimed in any one of claims 1 - 6.

9. An electronic device, comprising a memory, a processor, and a computer program stored on the memory and capable of being run on the processor, wherein the processor, upon executing the program, performs the method as claimed in any one of claims 1 - 6.

10. A storage medium, the storage medium comprising a stored program, wherein, when the program is run, a device comprising the storage medium is controlled to perform the method as claimed in any one of claims 1 - 6.

Fig. 1a

Fig. 1b

Fig. 2

Fig. 3

## INTERNATIONAL SEARCH REPORT

| International application No. |
| --- |
| **PCT/CN2020/114896** |

**A.   CLASSIFICATION OF SUBJECT MATTER**

G06F 30/28(2020.01)i; G06Q 10/04(2012.01)i

According to International Patent Classification (IPC) or to both national classification and IPC

**B.   FIELDS SEARCHED**

Minimum documentation searched (classification system followed by classification symbols)

G06F G06Q G01N

Documentation searched other than minimum documentation to the extent that such documents are included in the fields searched

Electronic data base consulted during the international search (name of data base and, where practicable, search terms used)

CNPAT, CNKI, WPI, EPODOC: 污染, 大气, 环境, 预估, 预测, 预报, 高斯, 流体力学, CFD, 浓度, 高精度, 低精度, 样本, 数据融合, pollutant+, atmosphere, environment, predict+, estimat+, gauss+, fluid 3w dynamic+, concentration, high, low, precision, accuracy, sampl+, fus+ 3d data

**C.   DOCUMENTS CONSIDERED TO BE RELEVANT**

| Category* | Citation of document, with indication, where appropriate, of the relevant passages | Relevant to claim No. |
| --- | --- | --- |
| Y | CN 111144055 A (SOOCHOW UNIVERSITY) 12 May 2020 (2020-05-12)<br>  description paragraphs [0011]-[0015], [0057]-[0173], figures 1-16 | 1-10 |
| Y | CN 106709127 A (INTERNATIONAL BUSINESS MACHINES CORPORATION) 24 May 2017 (2017-05-24)<br>  description, paragraphs [0005]-[0068], and figures 1-6 | 1-10 |
| A | CN 104008229 A (PEKING UNIVERSITY) 27 August 2014 (2014-08-27)<br>  entire document | 1-10 |
| A | CN 110457829 A (WANG, Bo) 15 November 2019 (2019-11-15)<br>  entire document | 1-10 |
| A | CN 111222685 A (JIANGSU FANGTIAN POWER TECHNOLOGY CO., LTD.) 02 June 2020 (2020-06-02)<br>  entire document | 1-10 |
| A | CN 106651036 A (DONGGUAN UNIVERSITY OF TECHNOLOGY) 10 May 2017 (2017-05-10)<br>  entire document | 1-10 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **24 May 2021** | **09 June 2021** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2020/114896** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2020011843 A1 (INTERNATIONAL BUSINESS MACHINES CORPORATION) 09 January 2020 (2020-01-09) entire document | 1-10 |

Form PCT/ISA/210 (second sheet) (January 2015)

<table>
<tr><td colspan="2" align="center">INTERNATIONAL SEARCH REPORT<br>Information on patent family members</td><td colspan="2">International application No.<br><br>**PCT/CN2020/114896**</td></tr>
</table>

| Patent document cited in search report | | | Publication date (day/month/year) | Patent family member(s) | | | Publication date (day/month/year) |
|---|---|---|---|---|---|---|---|
| CN | 111144055 | A | 12 May 2020 | None | | | |
| CN | 106709127 | A | 24 May 2017 | DE | 102016221283 | A1 | 18 May 2017 |
| | | | | US | 10372846 | B2 | 06 August 2019 |
| | | | | US | 2017140075 | A1 | 18 May 2017 |
| | | | | CN | 106709127 | B | 16 March 2021 |
| CN | 104008229 | A | 27 August 2014 | CN | 104008229 | B | 09 June 2017 |
| CN | 110457829 | A | 15 November 2019 | CN | 110457829 | B | 01 May 2020 |
| CN | 111222685 | A | 02 June 2020 | None | | | |
| CN | 106651036 | A | 10 May 2017 | None | | | |
| US | 2020011843 | A1 | 09 January 2020 | US | 2017292938 | A1 | 12 October 2017 |
| | | | | US | 10481141 | B2 | 19 November 2019 |
| | | | | US | 9766220 | B2 | 19 September 2017 |
| | | | | US | 2017227509 | A1 | 10 August 2017 |

Form PCT/ISA/210 (patent family annex) (January 2015)